# EUROPEAN PATENT SPECIFICATION

(11) **EP 2 689 458 B1**
(45) Date of publication and mention of the grant of the patent: **10.01.2018**
(21) Application number: 12714374.1
(22) Date of filing: 20.03.2012
(51) Int. Cl.: H01L 33/00, H01L 33/50, H01L 33/54, H01L 33/62

(54) **PATTERNED UV SENSITIVE SILICONE-PHOSPHOR LAYER OVER LEDS, AND METHOD FOR FABRICATING THE SAME**
GEMUSTERTE UV-EMPFINDLICHE SILIKONPHOSPHORSCHICHT ÜBER LEDS UND VERFAHREN ZUR HERSTELLUNG DERSELBEN
COUCHE À MOTIFS ET EN SILICONE FLUORESCENT SENSIBLE AUX ULTRAVIOLETS SUR DIODES ÉLECTROLUMINESCENTES ET PROCÉDÉ DE FABRICATION CORRESPONDANT

(30) Priority: 25.03.2011 US 201161467426 P
(43) Date of publication of application: 29.01.2014
(73) Proprietor: Koninklijke Philips N.V., 5656 AE Eindhoven (NL)
(72) Inventor: BASIN, Grigoriy, NL-5656 AE Eindhoven (NL); MARTIN, Paul, Scott, NL-5656 AE Eindhoven (NL)
(74) Representative: Rüber, Bernhard Jakob
(86) International application number: PCT/IB2012/051320
(87) International publication number: WO 2012/131532

(56) References cited:
- EP-A2- 1 198 016
- WO-A1-2007/049187
- US-A1- 2010 276 716
- US-A1- 2011 031 516

## Description

### FIELD OF THE INVENTION

This invention relates to forming a phosphor layer or other wavelength conversion layer over light emitting diodes (LEDs) and, in particular, to a method for forming such a layer over LED dies mounted on a submount tile.

### BACKGROUND

It is common for the light from an LED die to be converted to a different color, such as white light, by depositing a phosphor over the LED die.

It is known to mount individual LED dies, singulated from an LED wafer, on a submount tile and then further process the dies on the tile to speed up processing. Such submount tiles may be populated with, for example, 2000 LED dies.

While the LED dies are mounted on the submount tile, phosphor is typically sprayed over the dies, molded over the dies, printed over the dies, deposited by electrophoresis, or deposited using other methods. In some cases, phosphor particles are infused in a heat-curable silicone binder, and the mixture is deposited over the LED dies. The mixture is then cured by heat.

In cases where the phosphor layer is deposited over the entire surface of the tile, as well as over the LED dies, the phosphor undesirably covers reflective metallization on the tile that is intended to reflect any downward LED light away from the submount after the tile is singulated. Additionally, the phosphor may cover a small wire bond electrode on a top surface of the LED dies. Additionally, it may be desirable to only provide a constant thickness of the phosphor around the sides of the LED dies so as to provide uniform color around the LED dies. In all such cases, a special masking and etching process must be performed to remove the undesired phosphor. Etching processes are time-consuming and relatively expensive, so add cost to the resulting LEDs.

After all tile-level processes have been completed, the tile is singulated to create the individual phosphor-converted LEDs.

US 2010/0276716 A1 discloses a light emitting diode coating method to coat a phosphor on an LED. The LED coating method includes (a) preparing a substrate and a plurality of LEDs arranged on the substrate; (b) applying a photoresist onto the substrate and the plurality of LEDs; and (c) selectively exposing the photoresist to light to form a first coating on surfaces of the plurality of LEDs. WO 2007/049187 A1 discloses a process for providing sheets with wavelength converting material to LED dies.

US 2011/0031516 A1 discloses a method for fabricating a light emitting device where an array of flip-chip light emitting diode (LED) dies are mounted on a submount wafer. Over each of the LED dies is simultaneously molded a hemispherical first silicone layer. A preformed flexible phosphor layer, comprising phosphor powder infused in silicone, is laminated over the first silicone layer.

EP 1 198 016 A2 discloses a light emitting device comprising a luminescent material containing a curable silicone polymer layer.

What is needed is a process that does not require etching of the phosphor over the tile or LED dies.

### SUMMARY

The method of the invention and the light emitting diode structure of the invention are defined in the claims.

This summary describes only a few embodiments of the invention. Other embodiments are envisioned.

LED dies are mounted a single submount tile (or wafer). The LED dies have a light emitting top surface. In one embodiment, the growth substrate is removed from the semiconductor surface by laser lift-off after the LED dies are mounted on the submount tile. A pre-formed sheet of UV sensitive silicone infused with phosphor is then laminated over the tile, including over the tops and sides of the LED dies. Only the silicone/phosphor layer over the top and sides of the LED dies is desired, so the silicone/phosphor layer directly on the tile needs to be removed.

In another embodiment, a liquid silicone/phosphor layer is spun on, sprayed on, screen printed on, molded over, or deposited on the tile and LED dies in other ways.

The silicone/phosphor layer is then masked to expose the areas that are to remain. UV light is then applied to the silicone/phosphor layer exposed through the mask, which creates a cross-linked material that will remain after the silicone/phosphor layer is developed using a solvent. The silicone acts as a negative photoresist. The unexposed silicone/phosphor layer is then dissolved with a solvent, and the remaining silicone/phosphor layer over the top and sides of the LED dies is then rinsed and dried.

In one embodiment, the LEDs are flip dies, and no area on the top surfaces of the LED dies needs to be electrically contacted. In another embodiment, if the LED dies require one or more top wire bonds, the mask blocks the UV light in those areas, so the silicone/phosphor layer is removed from the wire bond areas.

The selective removal of the silicone/phosphor layer: 1) allows reflective metallization surrounding the LED dies to reflect the downward LED light for increased efficiency; 2) causes the light emitted by the LED and phosphor to be more uniform around the LED die; and 3) enables wire bonding to top areas of the LED dies. Since no etching is needed, the process is performed quickly, cleanly, and inexpensively.

After any additional wafer-level processes, the tile is then singulated to produce individual phosphor-converted LEDs.

Instead of phosphor particles being infused in the silicone, light scattering particles or other materials may be infused. In an embodiment where the silicone is just used as an encapsulant and/or a lens, there may be no materials infused in the silicone.

### BRIEF DESCRIPTION OF THE DRAWINGS

Fig. 1 is a cross-sectional view of a small portion of a submount tile, showing two LED dies having their electrodes bonded to pads on the submount tile.
Fig. 2 illustrates a supporting film, a layer of UV sensitive silicone infused with phosphor deposited over it, and a protective film over the silicone/phosphor layer.
Fig. 3 illustrates the silicone/phosphor layer laminated over the submount tile.
Fig. 4A illustrates a mask selectively exposing the silicone/phosphor layer over the entire top surface of the LED die to UV light.
Fig. 4B illustrates a mask selectively exposing the silicone/phosphor layer to UV light over only a portion of the top surface of the LED die to allow wire bonding to a top electrode of the LED dies. In this example, the LED dies are vertical dies with one electrode on the bottom and a wire bond electrode on top.
Fig. 5A illustrates the silicone/phosphor layer of Fig. 4A after the unexposed silicone/phosphor layer is removed by a solvent.
Fig. 5B illustrates the silicone/phosphor layer of Fig. 4B after the unexposed silicone/phosphor layer is removed by a solvent and a wire is bonded to the top electrode.
Fig. 6 is a flowchart identifying steps in two alternative processes in accordance with some embodiments of the invention.

Elements that are the same or equivalent are labeled with the same numeral.

### DETAILED DESCRIPTION

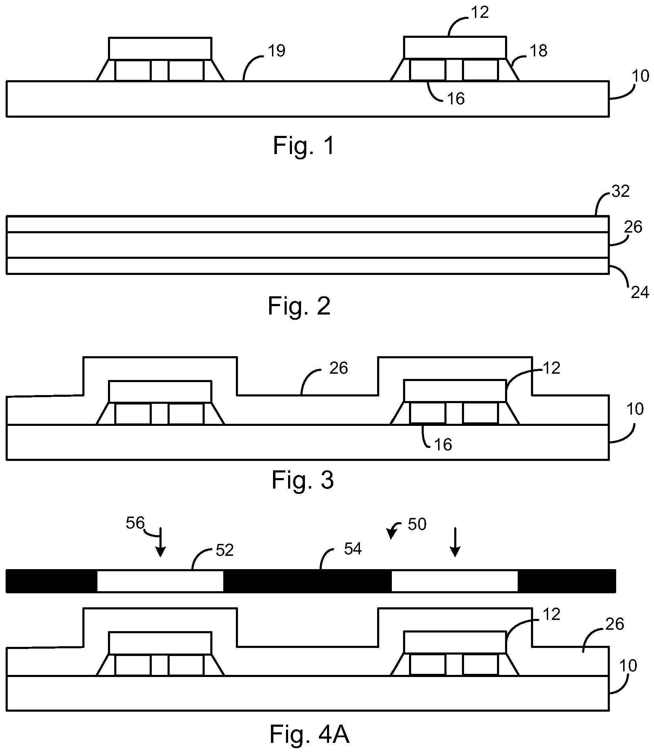

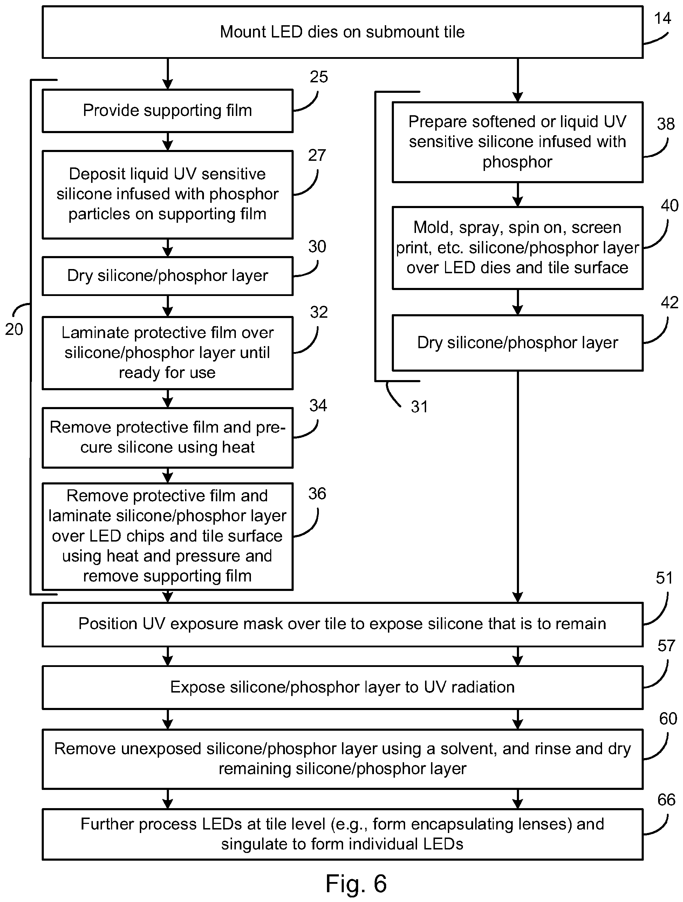

Figs. 1-6 represent only a few embodiments of the invention. Many other embodiments are envisioned. The process shown in Figs. 1-5 will be described while referring to the flowchart of Fig. 6. Fig. 6. illustrates two alternative process flows, a lamination flow 20 and a molding flow 31. Several process steps are common to both flows.

Fig. 1 illustrates a submount tile 10 populated with an array of conventional LED dies 12, as identified in step 14 of Fig. 6. There may be thousands of dies 12 bonded to the tile 10. Typical shapes of the submount tile 10 are rectangular and circular. The submount base material may be ceramic, silicon, insulated aluminum, or other material. The LED dies 12 comprise semiconductor layers that have been epitaxially grown over a growth substrate, such as sapphire in the case of GaN based LED dies. An active layer sandwiched between a p-type layer and an n-type layer generates light. The LED dies 12 are mounted to the submount tile 10. After mounting the LED dies 12 to the tile 10, the growth substrate is removed from over the top surface of the semiconductor layers by laser lift-off. The dies 12 in Fig. 1 are flip chips, with both electrodes 16 formed on the bottom surface. The LED die electrodes 16 may be ultrasonically bonded to metal pads formed on the submount tile 10 surface. The submount tile 10 pads lead to more robust electrodes on the bottom surface of the tile 10 (using conductive vias) for surface mounting to a printed circuit board.

An underfill material 18 is injected or molded between the LED dies 12 and the surface of tile 10.

In one example, the submount tile 10 has a reflective metal surface 19 outside the footprint of the LED dies 12 to reflect any downward light to increase efficiency. The reflective metal may be an enlarged bond pad of the submount tile 10. It is therefore desirable for such reflective metal to not be covered with any phosphor. There may be other reasons for not wanting a layer of phosphor over the surface of tile 10.

In one embodiment, identified in lamination flow 20 of Fig. 6, a silicone/phosphor layer is laminated over the tile 10 and dies 12. Fig. 2 illustrates the construction of one embodiment of the silicone/phosphor layer. A non-stick supporting film 24, such as a plastic film with a layer of Teflon or other suitable material, provides a temporary support for the silicone/phosphor layer. (Step 25 in Fig. 6.) A liquid slurry of a UV sensitive silicone infused with phosphor particles is prepared and sprayed one, spun on, printed on, or deposited over the supporting film 24 by any other technique to form a silicone/phosphor layer 26. (Step 27 in Fig. 6.) The type of phosphor used depends on the desired color to generate. For example, for an LED die 12 that generates blue light, a YAG phosphor, or a combination of red and green phosphors, may be used to create white light. The phosphor particle density and thickness of the layer 26 determines the color emitted by the complete device. Typically, the silicone/phosphor layer 26 will be between 20-200 microns thick. The layer 26 will be of uniform thickness. The layer 26 may include other materials, such as light scattering TiO2, ZrO, or silica particles. UV sensitive silicones and suitable phosphors are commercially available.

The silicone/phosphor layer 26 is then dried by heat to form a solid layer. (Step 30 in Fig. 6.) A protective film 32 is then attached over the silicone/phosphor layer 26. (Step 32 in Fig. 6.) The resulting layered structure may be cut to the dimensions of the submount tile 10 and stacked for later use.

Prior to laminating the silicone/phosphor layer 26 onto the tile 10, the protective film 32 is removed, and the silicone/phosphor layer 26 is pre-cured at 50-150°C for 1-10 minutes to achieve a film hardness that prevents the silicone from deforming during the lamination step and maintains the target thickness of layer 26 over the LED dies 12. (Step 34 in Fig. 6.)

The silicone/phosphor layer 26 is then positioned over the tile 10 with the supporting film 24 facing away from the tile 10. The layer 26 is then laminated under heat and pressure to adhere to the tile 10 and LED dies 12, as shown in Fig. 3. Air is removed by performing the lamination process under vacuum conditions. The layer 26 will be conformal over the surface, including over the LED dies 12. (Step 36 of Fig. 6.) The supporting film 24 is then removed.

As an alternative to laminating the pre-formed layer 26 onto the tile 10 as in lamination flow 20, the liquid UV sensitive silicone infused with phosphor may be prepared as a slurry (step 38, molding flow 31 of Fig. 6), then deposited over the tile 10 and dies 12 in any number of ways. Such ways include molding, spraying, spinning on, screen printing, and other suitable deposition techniques (step 40 of Fig. 6). The deposited liquid silicone/phosphor layer 26 of Fig. 3 is then dried. (Step 42 of Fig. 6.)

Fig. 4A illustrates a mask 50 positioned over the tile 10. (Step 51 of Fig. 6.) The mask 50 may be chrome-plated glass. The mask 50 has transparent portions 52 that define areas of the silicone/phosphor layer 26 that will remain after the development step. Opaque portions 54 define areas of the silicone/phosphor layer 26 which will be removed. A UV source emitting light 56 having a peak wavelength of about 365 nm selectively exposes the silicone/phosphor layer 26 over the entire top surface of the LED dies 12 to create cross-linkages in the silicone/phosphor layer 26. (Step 57 of Fig. 6.)

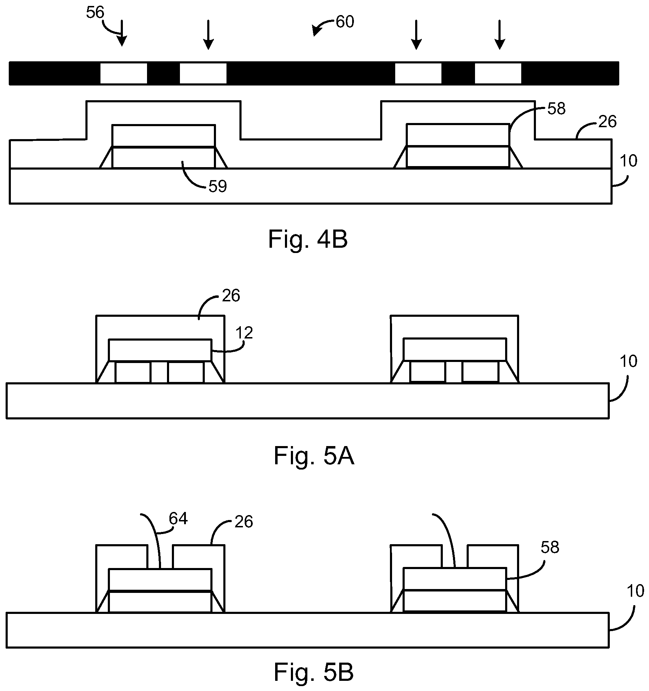

As shown in Fig. 4B, if the LED dies 58 were vertical LED dies, with a top wire bond electrode and a large bottom reflector electrode 59, the silicone/phosphor layer 26 must be removed from the wire bond electrode. Fig. 4B illustrates a mask 60 selectively exposing the silicone/phosphor layer 26 to the UV light 56 over only a portion of the top surface of the LED dies 58 to ultimately allow wire bonding to the top electrode.

After the exposure step, the tile 10 is dipped in a solvent to dissolve the unexposed silicone/phosphor layer 26. This step may also be referred to as developing the silicone/phosphor layer 26. The solvent may be heptaine, which does not dissolve the cross-linked silicone/phosphor layer 26. (Step 60 of Fig. 6.) The remaining silicone/phosphor layer 26 is then rinsed with di-ionized water and dried. The drying may be at 120-150°C for 1-4 hours.

Fig. 5A illustrates the silicone/phosphor layer 26 of Fig. 4A after the unexposed silicone/phosphor layer 26 is removed by the solvent.

Fig. 5B illustrates the silicone/phosphor layer 26 of Fig. 4B after the unexposed silicone/phosphor layer 26 is removed by a solvent and a wire 64 is bonded to the top electrode by conventional techniques.

In one embodiment, silicone lenses are then molded over the LED dies 12/58 while on the tile 10, and the tile 10 is then sawed to singulate the LED/submount units. (Step 66 of Fig. 6.) Additional tile level processes may be performed.

The resulting silicone/phosphor layer 26 is conformal and produces substantially uniform color around the LED die.

Although UV sensitive silicone is used in the example according to the invention, other UV sensitive materials may also be used in examples not according to the invention, but such materials should be non-yellowing when exposed to prolonged light and heat from the LED dies.

Instead of a wavelength converting phosphor infused in the silicone, other particles may be use for wavelength conversion or for other purposes, such as light scattering. Further, the silicone may not contain any particles and may only be used as a lens or an encapsulant.

The UV sensitive layer need not cover the entire tile, but it is desirable that it cover at least all the LED dies and the tile surface between the LED dies.

Although a negative photo-material has been described that becomes non-dissolvable by exposure to the radiation, a positive photo-material may instead be used that becomes dissolvable when exposed to the radiation. If such a material is used, the transparent and opaque portions of the masks of Figs. 4A and 4B would be reversed.

While particular embodiments of the present invention have been shown and described, it will be obvious to those skilled in the art that changes and modifications may be made without departing from this invention as defined by the claims.

## Claims

1. A method for fabricating a light emitting diode (LED) structure comprising:
providing a plurality of LED dies (12) on a submount tile (10), each LED die comprising a plurality of semiconductor layers, each LED die having a top light emitting surface;
providing a UV sensitive layer (26) over the LED dies and surface of the tile between the LED dies;
masking the UV sensitive layer using a mask (50);
selectively exposing the UV sensitive layer to UV radiation through the mask; and
dissolving portions of the UV sensitive layer defined by the mask, using a solvent, to leave the UV sensitive layer remaining over at least portions of the light emitting surface of the LED dies but removing the UV sensitive layer over at least portions of the surface of the tile,
**characterized in that** the UV sensitive layer is preformed and is made of UV sensitive silicone.

2. The method of Claim 1 wherein the UV sensitive silicone is substantially undissolvable by the solvent after exposure to UV radiation.

3. The method of Claim 1 wherein the UV sensitive silicone, after dissolving portions of the UV sensitive silicone defined by the mask, conformally coats the LED dies.

4. The method of Claim 1 wherein the UV sensitive silicone, after dissolving portions of the UV sensitive silicone defined by the mask, conformally coats the top light emitting surface of the LED dies as well as side surfaces of the LED dies.

5. The method of Claim 1 wherein the UV sensitive silicone, after dissolving portions of the UV sensitive silicone defined by the mask, remains on a portion of the top light emitting surface of the LED dies and exposes a wire bond electrode of the LED dies.

6. The method of Claim 1 wherein the step of providing a UV sensitive silicone over the LED dies and surface of the tile between the LED dies comprises:
providing a supporting film;
depositing the UV sensitive silicone as a liquid layer over the supporting film;
drying the UV sensitive silicone to a state harder than a liquid;
laminating the UV sensitive silicone to the LED dies and tile; and
removing the supporting film.

7. The method of Claim 1 wherein the UV sensitive silicone is infused with wavelength conversion material.

8. The method of Claim 7 wherein the wavelength conversion material is phosphor.

9. The method of Claim 1 wherein the UV sensitive silicone includes light scattering particles.

10. The method of Claim 1 further comprising singulating the tile.

11. A light emitting diode (LED) structure comprising:
an LED die (12) mounted on a submount (10), the LED die comprising a plurality of semiconductor layers, the LED die having a top light emitting surface and a top wire bond electrode, the submount having a surface that extends beyond a footprint of the LED die; and
a layer of cross-linked silicone (26) over at least a portion of the top light emitting surface of the LED die, the cross-linked silicone comprising a UV sensitive silicone that has reacted with UV radiation to allow masked UV light to define at least one area of the silicone that is cross-linked, and at least one area on the submount that does not contain cross-linked silicone,
**characterized in that** said layer of cross-linked silicone is present over only a portion of said top light emitting surface of the LED die such that wire (64) bonding to the top electrode is allowed.

12. The structure of Claim 11 wherein the cross-linked silicone is substantially undissolvable by a solvent after the exposure to UV radiation.

13. The structure of Claim 11 wherein the cross-linked silicone conformally coats the LED die.

14. The structure of Claim 11 wherein the cross-linked silicone contains a wavelength conversion material.

## Patentansprüche

1. Verfahren zum Herstellen einer Leuchtdioden- (LED) Struktur, umfassend folgende Schritte:
Bereitstellen einer Vielzahl von LED-Chips (12) auf einer Barrenkachel (10), wobei jeder LED-Chip eine Vielzahl von Halbleiterschichten umfasst, wobei jeder LED-Chip eine obere lichtemittierende Oberfläche aufweist;
Bereitstellen einer UV-empfindlichen Schicht (26) über den LED-Chips und der Oberfläche der Kachel zwischen den LED-Chips;
Maskieren der UV-empfindlichen Schicht unter Verwendung einer Maske (50);
selektives Bestrahlen der UV-empfindlichen Schicht mit UV-Strahlung durch die Maske hindurch; und
Auflösen von Abschnitten der UV-empfindlichen Schicht, die durch die Maske definiert sind, unter Verwendung eines Lösemittels, um die UV-empfindliche Schicht mindestens über gewissen Abschnitten der lichtemittierenden Oberfläche der LED-Chips zurückzulassen aber die UV-empfindliche Schicht mindestens über gewissen Abschnitten der Oberfläche der Kachel zu entfernen,
**dadurch gekennzeichnet, dass** die UV-empfindliche Schicht vorgeformt ist und aus UV-empfindlichen Silikon besteht.

2. Verfahren nach Anspruch 1, wobei das UV-empfindliche Silikon im Wesentlichen durch das Lösemittel nach dem Bestrahlen mit UV-Strahlung unauflöslich ist.

3. Verfahren nach Anspruch 1, wobei das UV-empfindliche Silikon nach dem Auflösen von gewissen Abschnitten des UV-empfindlichen Silikons, die durch die Maske definiert sind, die LED-Chips gleichförmig beschichtet.

4. Verfahren nach Anspruch 1, wobei das UV-empfindliche Silikon nach dem Auflösen von gewissen Abschnitten des UV-empfindlichen Silikons, die durch die Maske definiert sind, die obere lichtemittierende Oberfläche der LED-Chips sowie die Seitenflächen der LED-Chips gleichförmig beschichtet.

5. Verfahren nach Anspruch 1, wobei das UV-empfindliche Silikon nach dem Auflösen von gewissen Abschnitten des UV-empfindlichen Silikons, die durch die Maske definiert sind, auf einem Abschnitt der oberen lichtemittierenden Oberfläche der LED-Chips zurückbleibt und eine drahtgebondete Elektrode der LED-Chips freilegt.

6. Verfahren nach Anspruch 1, wobei der Schritt des Bereitstellens eines UV-empfindlichen Silikons über den LED-Chips und der Oberfläche der Kachel zwischen den LED-Chips Folgendes umfasst:
Bereitstellen einer Trägerfolie;
Abscheiden des UV-empfindlichen Silikons als flüssige Schicht über die Trägerfolie;
Trocknen des UV-empfindlichen Silikons bis auf einen Zustand, der härter als eine Flüssigkeit ist;
Laminieren des UV-empfindlichen Silikons auf die LED-Chips und Kachel; und
Entfernen der Trägerfolie.

7. Verfahren nach Anspruch 1, wobei das UV-empfindliche Silikon mit Wellenlängenumwandlungsmaterial versetzt ist.

8. Verfahren nach Anspruch 7, wobei das Wellenlängenumwandlungsmaterial Phosphor ist.

9. Verfahren nach Anspruch 1, wobei das UV-empfindliche Silikon lichtstreuende Teilchen umfasst.

10. Verfahren nach Anspruch 1, ferner umfassend das Vereinzeln der Kachel.

11. Leuchtdioden- (LED) Struktur, umfassend:
einen LED-Chip (12), der auf einem Barren (10) montiert ist, wobei der LED-Chip eine Vielzahl von Halbleiterschichten umfasst, wobei der LED-Chip eine obere lichtemittierende Oberfläche und eine obere drahtgebondete Elektrode umfasst, wobei der Barren eine Oberfläche aufweist, die sich über eine Anschlussfläche des LED-Chips hinaus erstreckt; und
eine Schicht aus vernetztem Silikon (26) über mindestens einem Abschnitt der oberen lichtemittierenden Oberfläche des LED-Chips, wobei das vernetzte Silikon ein UVempfindliches Silikon umfasst, das auf die UV-Strahlung reagiert hat, damit das maskierte UV-Licht mindestens einen Bereich des Silikons, der vernetzt ist, und mindestens einen Bereich auf dem Barren, der kein vernetztes Silikon enthält, definieren kann,
**dadurch gekennzeichnet, dass** die Schicht aus vernetztem Silikon nur über einem Abschnitt der oberen lichtemittierenden Oberfläche des LED-Chips vorliegt, so dass ein Drahtbonden (64) mit der oberen Elektrode möglich ist.

12. Struktur nach Anspruch 11, wobei das vernetzte Silikon im Wesentlichen durch ein Lösemittel nach der Belichtung mit UV-Strahlung unauflöslich ist.

13. Struktur nach Anspruch 11, wobei das vernetzte Silikon den LED-Chip gleichförmig beschichtet.

14. Struktur nach Anspruch 11, wobei das vernetzte Silikon ein Wellenlängenumwandlungsmaterial enthält.

## Revendications

1. Procédé pour fabriquer une structure de diode électroluminescente (DEL) comprenant :
la fourniture d'une pluralité de puces de DEL (12) sur une tuile d'embase (10), chaque puce de DEL comprenant une pluralité de couches semi-conductrices, chaque puce de DEL ayant une surface d'émission de lumière supérieure ;
la fourniture d'une couche sensible aux UV (26) sur les puces de DEL et la surface de la tuile entre les puces de DEL ;
le masquage de la couche sensible aux UV en utilisant un masque (50) ;
l'exposition de manière sélective de la couche sensible aux UV à un rayonnement UV à travers le masque ;
la dissolution de parties de la couche sensible aux UV définies par le masque, en utilisant un solvant, pour laisser la couche sensible aux UV restant sur au moins des parties de la surface d'émission de lumière des puces de DEL, mais retirer la couche sensible aux UV sur au moins des parties de la surface de la tuile,
**caractérisé en ce que** la couche sensible aux UV est préformée et est constituée de silicone sensible aux UV.

2. Procédé selon la revendication 1, dans lequel la silicone sensible aux UV est sensiblement impossible à dissoudre par le solvant après une exposition à un rayonnement UV.

3. Procédé selon la revendication 1, dans lequel la silicone sensible aux UV, après la dissolution de parties de la silicone sensible aux UV définies par le masque, revêt de manière conforme les puces de DEL.

4. Procédé selon la revendication 1, dans lequel la silicone sensible aux UV, après la dissolution de parties de la silicone sensible aux UV définies par le masque, revêt de manière conforme la surface d'émission de lumière supérieure des puces de DEL ainsi que les surfaces latérales des puces de DEL.

5. Procédé selon la revendication 1, dans lequel la silicone sensible aux UV, après la dissolution de parties de la silicone sensible aux UV définies par le masque, reste sur une partie de la surface d'émission de lumière supérieure des puces de DEL et expose une électrode de liaison par fil des puces de DEL.

6. Procédé selon la revendication 1, dans lequel l'étape de fourniture d'une silicone sensible aux UV sur les puces de DEL et la surface de la tuile entre les puces de DEL comprend :
la fourniture d'un film de support ;
le dépôt de la silicone sensible aux UV en tant que couche liquide sur le film de support ;
le séchage de la silicone sensible aux UV en un état plus dur qu'un liquide ;
la lamification de la silicone sensible aux UV sur les puces de DEL et la tuile ; et
le retrait du film de support.

7. Procédé selon la revendication 1, dans lequel un matériau de conversion de longueur d'onde est infusé dans la silicone sensible aux UV.

8. Procédé selon la revendication 7, dans lequel le matériau de conversion de longueur d'onde est le phosphore.

9. Procédé selon la revendication 1, dans lequel la silicone sensible aux UV comprend des particules de diffusion de lumière.

10. Procédé selon la revendication 1, comprenant en outre la singularisation de la tuile.

11. Structure de diode électroluminescente (DEL) comprenant :
une puce de DEL (12) montée sur une embase (10), la puce de DEL comprenant une pluralité de couches semi-conductrices, la puce de DEL ayant une surface d'émission de lumière supérieure et une électrode de liaison par fil supérieure, l'embase ayant une surface qui s'étend au-delà d'une empreinte de la puce de DEL ; et
une couche de silicone réticulée (26) sur au moins une partie de la surface d'émission de lumière supérieure de la puce de DEL, la silicone réticulée comprenant une silicone sensible aux UV qui a réagi avec un rayonnement UV pour permettre à la lumière UV masquée de définir au moins une zone de la silicone qui est réticulée, et au moins une zone sur l'embase qui ne contient pas de silicone réticulée,
**caractérisée en ce que** ladite couche de silicone réticulée est présente uniquement sur une partie de ladite surface d'émission de lumière supérieure de la puce de DEL de sorte qu'une liaison par un fil (64) à l'électrode supérieure soit possible.

12. Structure selon la revendication 11, dans laquelle la silicone réticulée est sensiblement impossible à dissoudre par un solvant après l'exposition à un rayonnement UV.

13. Structure selon la revendication 11, dans laquelle la silicone réticulée revêt de manière conforme la puce de DEL.

14. Structure selon la revendication 11, dans laquelle la silicone réticulée contient un matériau de conversion de longueur d'onde.
